(19) **Europäisches Patentamt**

**European Patent Office**

**Office européen des brevets**

(11) **EP 0 889 588 B1**

(12) **EUROPÄISCHE PATENTSCHRIFT**

(45) Veröffentlichungstag und Bekanntmachung des Hinweises auf die Patenterteilung:
**11.06.2003   Patentblatt 2003/24**

(51) Int Cl.7: **H03H 17/06**

(21) Anmeldenummer: **97110914.5**

(22) Anmeldetag: **02.07.1997**

(54) **Filterkombination zur Abtastratenumsetzung**

Filter combination for sample rate conversion

Combinaison de filtres pour la conversion de la fréquence d'échantillonnage

(84) Benannte Vertragsstaaten:
**DE FR GB IT NL**

(43) Veröffentlichungstag der Anmeldung:
**07.01.1999   Patentblatt 1999/01**

(73) Patentinhaber: **Micronas Semiconductor Holding AG**
**8005 Zürich (CH)**

(72) Erfinder:
• **Menkhoff, Andreas, Dr.**
  **81927 München (DE)**
• **Alrutz, Herbert, Dr.rer.nat.**
  **79102 Freiburg (DE)**

(74) Vertreter: **Sauer, Wolfgang**
**MICRONAS INTERMETALL GmbH,**
**Patentabteilung,**
**Hans-Bunte-Strasse 19**
**79108 Freiburg (DE)**

(56) Entgegenhaltungen:
**EP-A- 0 052 847**

• **SCHÜSSLER ET AL: "ON PARTLY DIGITAL ANT-ALIASING FILTERS" ARCHIV DER ELEKTRISCHEN UBERTRAGUNG., Bd. 36, Nr. 9, September 1982, STUTTGART DE, Seiten 349-355, XP002049320**

## Beschreibung

Die Erfindung betrifft eine Filterkombination zur Umsetzung der Abtastrate eines digitalisierten Signals. Die ursprüngliche Abtastrate erfüllt dabei das Abtasttheorem, das besagt, daß das zu digitalisierende Signal bandbegrenzt ist und eine obere Grenzfrequenz aufweist, die kleiner als die halbe Abtastrate ist. Für die Erhöhung oder Erniedrigung der Abtastrate um beliebige Faktoren haben sich Filterkombinationen bewärt, die auch als hybride Systeme bezeichnet werden. Der Grundgedanke dabei ist, daß zunächst aus der tiefpaßgefilterten Eingangsdatenfolge ein analoges Signal gebildet wird, das mit der gewünschten Abtastrate wieder digitalisiert wird. In Zwischenstufen erfolgen selbstverständlich digitale und analoge Tiefpaßfilterungen, deren Grenzfrequenzen entsprechend den jeweiligen internen und externen Abtastraten und Signalfrequenzen angepaßt sind, damit in der Ausgangsdatenfolge keine Aliassignale entstehen.

Die Rekonstruktion eines analogen Signals innerhalb der Filterkombination mittels einer Digital/Analogumsetzung ist zwar grundsätzlich möglich, jedoch dient diese Betrachtungsweise vor allen Dingen der Erläuterung des Verfahrens. Für die tatsächliche Realisierung erweist sich die vollständige Rekonstruktion des analogen Signals als nicht erforderlich, denn über eine Interpolation der digitalen Abtastwerte lassen sich die gewünschten Zwischenwerte auf einer rein digitalen Ebene mit hoher Genauigkeit berechnen. Die Umsetzung in ein analoges Signal wäre ein unnötiger Umweg, der nicht erforderlich ist, denn für die Abtastratenumsetzung ist für jeweils einen neuen Abtastwert immer nur ein einziger Zwischenwert zwischen festen Stützwerten zu interpolieren. Der beidseitige analoge Signalverlauf zu diesem interpolierten Zwischenwert wird für die Ausgangsdatenfolge nicht benötigt Bei den festen Stützwerten kann es sich um tatsächliche und/oder interpolierte Abtastwerte handeln, in jedem Fall sind diese festen Stützwerte zeitlich durch ein fest vorgegebenes Abtastraster definiert. Das Filter, das die festen Stützwerte liefert, wird daher auch als festes oder zeitinvariantes Interpolationsfilter bezeichnet. In der Regel ist die Frequenz dieses neuen Abtastrasters um eine Zweierpotenz höher als die ursprüngliche Abtastfrequenz. Eine ausführliche Behandlung derartiger Filterkombinationen erfolgt beispielsweise in "IEEE, Transactions on Acoustics, Speech and Signal Processing", Bd. ASSP-32, Nr. 3, Juli 1984, Seiten 577 bis 591 unter dem Titel "Digital Methods for Conversion Between Arbitrary Sampling Frequendes", Autor: T.A. Ramstad.

In der EP-Patentanmeldung 96 11 9505.4 (= ITT Case: 1719) ist eine digitale Filterkombination zur Interpolation von Abtastwerten eines digitalisierten Signals beschrieben, mit der die Abtastrate digitalisierter Video- oder Audiosignale um ein beliebiges Zahlenverhältnis verändert werden kann. Die Schaltung enthält dabei ein festes Interpolationsfilter dritter Ordnung, mit dem die Anzahl der vorhandenen Abtastwerte durch die Bildung von interpolierten Zwischenwerten verdoppelt wird. Einer Periode des ursprünglichen Abtasttaktes sind nun zwei Abtastwerte zugeordnet. Dies kommt für die weitere Verarbeitung gleichsam einer Verdoppelung der ursprünglichen Abtastrate gleich, denn die zur Verfügung stehenden Abtastwerte entsprechen nun einem Abtastraster mit der halben Periodendauer. An das feste Interpolationsfilter schließt sich ein zeitvariables Interpolationsfilter zweiten Grades an, das aus der neuen Abtastfolge für beliebigen Zeitpunkte Zwischenwerte für die gewünschte Ausgangsdatenfolge berechnen kann.

Wenn die ein- und ausgangsseitige Abtastrate einander ähnlich sind, dann hält sich der Filteraufwand in Grenzen. Anders sieht es aus, wenn die beiden Abtastraten sehr unterschiedlich sind, weil dann durch Spiegelungen des vorhandenen Signalspektrums bei der neuen Abtastrate und den zugehörigen Frequenzvielfachwerten Aliassignale im Nutzspektrum entstehen können. Die Unterdrückung dieser Frequenzanteile im Signalspektrum, die meist vor der Abtastratenumsetzung durchgeführt ist, erfordert aufwendige Tiefpaßfilter, beispielsweise Transversalfilter mit langen Verzögerungsketten. Noch aufwendiger wird die Bandbegrenzung, wenn die Bandbreite in mehreren Schritten einstellbar sein muß, weil das Abtastratenverhältnis innerhalb bestimmter Grenzen beliebig einstellbar sein soll. Die Bandbegrenzung des Bandsignals kann somit leicht sehr viel aufwendiger werden als die eigentliche Abtastratenwandlung. Für Konsumanwendungen ist der Aufwand, mit dem eine bestimmte Funktion realisiert wird, eine wichtige Größe, denn je größer der Schaltungsaufwand ist, desto größer ist die dafür aufzubringende Halbleiterfläche bei der monolithischen Integration. Und der Halbleiterflächenzuwachs geht bekanntlich überproportional in die Herstellungskosten ein.

Es ist daher Aufgabe der Erfindung, den gesamten Schaltungsaufwand für eine beliebige Abtastratenumsetzung möglichst klein zu halten.

Die Lösung der Aufgabe wird durch eine Filterkombination entsprechend den Merkmalen des Anspruchs 1 erreicht. Der Grundgedanke der Erfindung besteht darin, daß die Schaltung zur Bandbegrenzung und die Schaltung zur Abtastratenwandlung miteinander verschmolzen werden. Dabei wird die Abtastratenwandlung und die damit verbundene Bandbegrenzung durch das Zusammenwirken an sich bekannter Filterstufen erreicht. Die Erfindung macht sich dabei zunutze, daß nicht nur der Durchlaß- und Sperrbereich des Eingangstiefpaßes für die erforderliche Bandbegrenzung entscheidend ist, sondern daß bei geschickter Kombination der an der Abtastratenumsetzung beteiligten Filter die Anforderung an das einzelne Filter reduziert werden kann, weil der resultierende gemeinsame Amplitudengang im interessierenden Frequenzbereich insgesamt eine ausreichende Signaldämpfung bewirkt. Hierbei werden auch die gespiegelten Bereiche der Amplitudengänge mit einbezogen, um störende Frequenzen und Frequenzvielfachwerte zu unterdrücken. Es brauchen dabei nur solche Störfrequenzen berücksichtigt zu werden, die in dem jeweiligen System auch tatsächlich auftreten können und nicht schon durch die grundsätzlichen Eigenschaften der Schaltungstechnologie, der Wiedergabeeinrichtung oder z.B. des Betrachters unterdrückt sind. Die erforderliche Signaldämpfung hängt auch von der subjektiven Störempfindlichkeit ab, die bei Videosignalen geringer als bei Audiosignalen ist

Die Filterkombination nach der Erfindung kann dazu dienen, den Verarbeitungstakt eines digitalisierten Signals an die tatsächliche Signalbandbreite anzupassen. Dies ist beispielsweise erforderlich, wenn eine Überabtastung vorliegt oder ein relativ schmalbandiges Signal in einem breitbandigen Signalgemisch enthalten ist. Die Abtastratenumsetzung kann aber auch den Signalinhalt verändern, beispielsweise komprimieren oder expandieren. Mit der Komprimierung kann der Speicherbedarf bei der Signalspeicherung reduziert werden. Die Erfindung ermöglicht eine Anpassung unterschiedlicher Abtastraten von Signalen, beispielsweise die Anpassung einer mit einem festen Takt verkoppelten Datenfolge an den vorgegebenen Systemtakt eines anderen Verarbeitungssystems. Bei Videosignalen ist dabei auch eine Änderung der Darstellungsgröße, insbesondere eine Verkleinerung, des jeweiligen Bildes auf dem Bildschirm eines Fernsehempfängers oder einer Multimediawiedergabeeinrichtung möglich. Es lassen sich auf diese Weise Standbilder, laufende Fernsehbilder, mit dem Rechner erzeugte Bilder oder die Bilder anderer Bildquellen in beliebig verkleinerter Form in einem Bildschirmfenster darstellen. Diese eingeblendeten Bilder können auch als Menüfelder dienen.

Die Filterkombination nach der Erfindung enthält im Eingang einen Eingangstiefpaß, der im Bereich der halben und 1,5-fachen Abtastfrequenz eine ausreichende Dämpfung hat Anschließend folgt das hybride Filtersystem aus einem festen und einem zeitvariablen Interpolationsfilter. Das hybride Filtersystem hat im Bereich der einfachen und doppelten Abtastfrequenz jeweils eine hohe Dämpfung. Der Dämpfungsverlauf zwischen der halben und 1,5-fachen Abtastfrequenz und bei den zugehörigen periodischen Spiegelbereichen ist zwar niedriger, aber insgesamt ausreichend. Hohe Dämpfungswerte bei bestimmten Frequenzbereichen lassen sich durch ein- oder mehrfache Nullstellen der Übertragungsfunktionen realisieren. Der Frequenzumfang dieser Sperrbereiche hängt vom Verlauf der Übertragungsfunktion, insbesondere der Anzahl der in diesem Frequenzbereich vorhandenen Nullstellen, und der gewünschten Dämpfung ab. Mit dem zeitvariablen Interpolationsfilter wird in der Regel eine Interpolation innerhalb einer Oktave realisiert Für größere Änderungen der Abtastfrequenz durchläuft das Signal dann noch eine Dezimierungseinrichtung mit einem zugehörigen Tiefpaß, der dann ebenfalls in die Filterkombination mit einbezogen wird. Besonders voreiteilhaft für die Reduktion des Schaltungsaufwandes ist es, wenn der ganzzahlige Dezimierungsfaktor eine variable Potenz von 2 ist, weil dann die Verstärkung der Dezimierungseinrichtung durch eine einfache Stellenverschiebung oder neue Stellenzuordnung der Ausgangsdaten rückgängig gemacht werden kann..

Die Erfindung und ein vorteilhaftes Ausführungsbeispiel wird nun anhand der Figuren der Zeichnung näher dargestellt:

Fig. 1 zeigt schematisch im Blockschaltbild eine Einrichtung zur Abtastratenumsetzung mit einer Filterkombination nach der Erfindung,

Fig. 2 zeigt im Frequenzdiagramm die Eingangsdatenfolge und den Amplitudengang der einzelnen Filter,

Fig. 3 zeigt im Blockschallbild ein einfaches Tiefpaßfilter,

Fig. 4 zeigt im Blockschaltbild ein festes Interpolationsfilter,

Fig. 5 zeigt das Blockschaltbild eines linearen Interpolationsfilters und

Fig. 6 zeigt das Blockschaltbild einer MTA-Dezimierungseinrichtung.

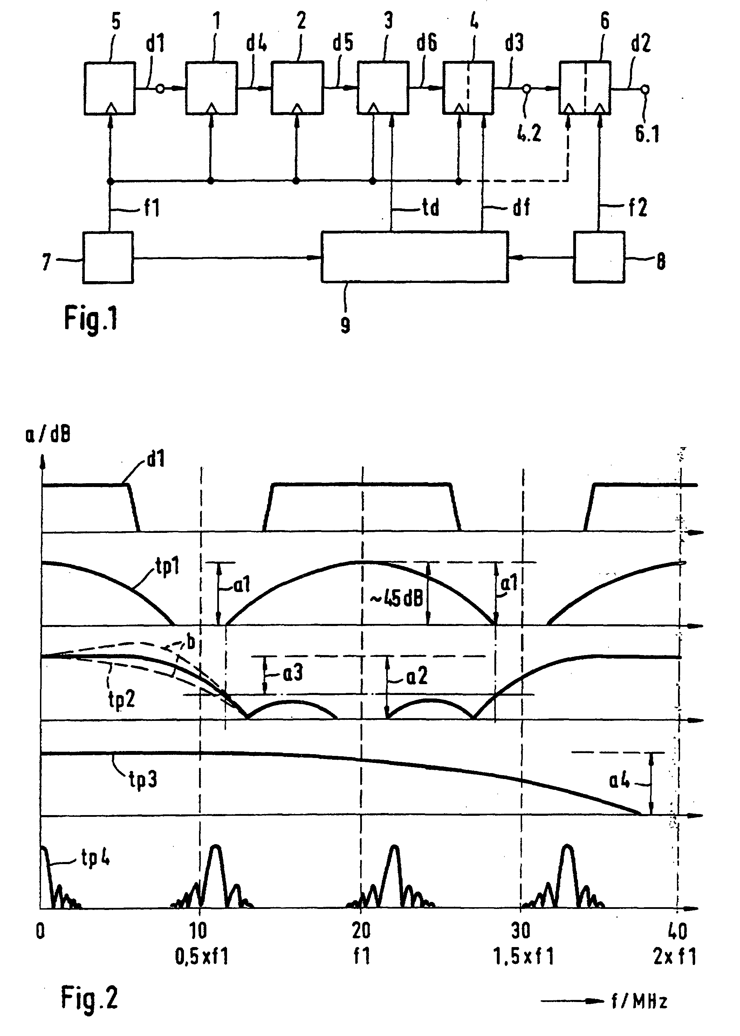

Fig. 1 zeigt eine Schaltung zur Abtastratenumsetzung mit einer Filterkombination 1,2,3 nach der Erfindung, die durch eine Dezimierungseinrichtung 4 erweitert ist. Die erweiterte Filterkombination ist zwischen einer Signalquelle 5 und einem Pufferspeicher 6 angeordnet, an dessen Ausgang 6.1 eine Ausgangsdatenfolge d2 mit der gewünschten Abtastfrequenz f2 abnehmbar ist. Mit der Signalquelle 5 ist eine erste Taktquelle 7 verbunden, die einen ersten Takt f1 liefert, der auch als Digitalisierungstakt oder Eingangtakt dient und damit die Datenrate einer Eingangsdatenfolge d1 bestimmt Eine zweite Taktquelle 8 liefert einen zweiten Takt f2, den Ausgangstakt, und ist wie die erste Taktquelle 7 mit einer Steuereinrichtung 9 verbunden.

Die Filterkombination enthält im Eingang einen Eingangstiefpaß 1, dessen Amplitudengang tp1 beispielsweise durch einen Tiefpaß zweiter Ordnung mit der Übertragungsfunktion $H(z) = (1 + z^{-1})^2$ realisiert ist. Dieser Tiefpaß 1 hat im Bereich der halben Abtastfrequenz $0,5 \times f1$ und damit auch beider 1,5-fachen Abtastfrequenz eine doppelte Nullstelle. Die Durchlaß- und Dämpfungskurve hat einen weichen Amplitudengang, so daß bereits Signale ab der 0,2-fachen Frequenz des Abtasttaktes f1 in der Amplitude gedämpft werden. Die Dämpfung bei der Nullstelle hat für einen größeren Frequenzbereich mindestens den Wert a1, vgl. Fig. 2. Am Ausgang des Eingangtiefpasses 1 ist eine Datenfolge d4 abgreifbar.

Dem Eingangstiefpaß 1 folgt ein festes Interpolationsfilter 2, das oft auch als Halbbandfilter bezeichnet wird. Es zeichnet sich dadurch aus, daß mit seiner Hilfe die Anzahl der Abtastwerte gegenüber der Eingangsdatenfolge d1 durch eine Interpolation verdoppelt wird. Die neue Abtastfolge wird als Datenfolge d5 an das nachfolgende zeitvariable Interpolationsfilter 3 abgegeben, wobei ein Teil der Werte parallel als Stützwerte zur Verfügung steht - der Verarbeitungstakt ist durch den ersten Takt f1 bestimmt Eine gleichzeitige Frequenzverdoppelung des Verarbeitungstaktes ist gegebenenfalls dort sinnvoll, wo diese Takterhöhung leicht möglich ist, z.B. weil die Datenrate der Datenfolge d1 wesentlich niedriger als der Systemtakt liegt.

Das feste Interpolationsfilter 2 enthält einen Tiefpaß dessen Amplitudengang tp2 so vorgegeben ist, daß im Bereich der Abtastfrequenz f1 mindestens eine doppelte Nullstelle mit der Dämpfung a2 (Fig. 2) vorhanden ist und etwa von der halben bis zur 1,5-fachen Abtastfrequenz der Dämpfungsverlauf mindestens den Wert a3 (Fig. 2) aufweist. Bei geeigneter Realisierung kann das feste Interpolationsfilter 2 so ausgebildet sein, daß die unerwünschte Dämpfung höherer Signalfrequenzen infolge des Eingangstiefpasses 1 durch eine gewissen Höhenanhebung wieder ausgeglichen wird. Die Kombination aus Eingangstiefpaß 1 und Interpolationsfilter 2 bildet für die Eingangsdatenfolge d1 einen resultierenden Tiefpaß, dessen Sperrbereich etwas unterhalb der halben Abtastfrequenz $0,5 \times f1$ beginnt und etwas über die 1,5-fache Abtastfrequenz hinaus reicht. Durch Frequenzspiegelung wiederholt sich das zwischen der 2,5-fachen und 3,5-fachen Abtastfrequenz und bei entsprechend höheren Frequenzen.

Bei einer Abtastfrequenz f1 von 20 MHz stören in der Regel auch die Signalkomponenten, die bei der doppelten Abtastfrequenz $2 \times f1$ liegen. Diese Signalkomponenten werden mittels der Filtereigenschaften eines zeitvariablen Interpolationsfilters 3 unterdrückt, das dem festen Interpolationsfilter 2 folgt. Die beliebigen Zeitwerten zugeordnete Interpolation findet in diesem zeitvariablen Inberpolationsfilter 3 statt, dessen Eingang mit den festen Stützwerten aus dem festen Interpolationsfilter 2 gespeist ist. Den Ausgangswerten der Interpolation entspricht eine Datenfolge d6, deren Werte synchron mit dem ersten Takt f1 ausgegeben werden. Die Verkopplung mit dem Ausgangstakt f2 findet in der Regel im zeitvariablen Interpolationsfilter 3 noch nicht statt.

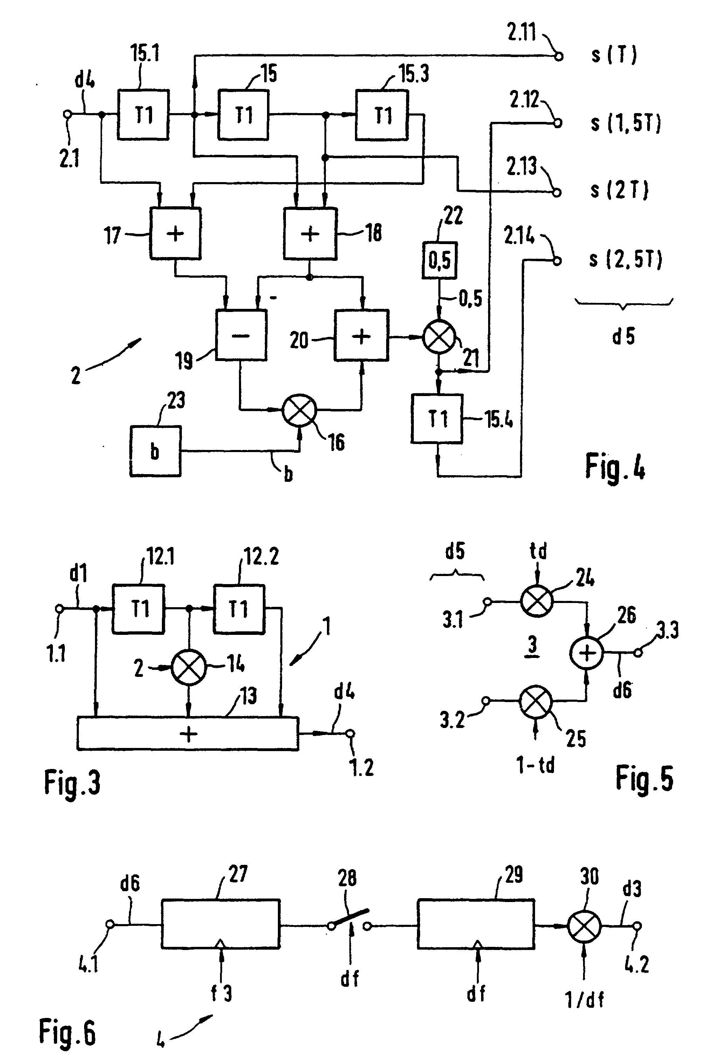

Im einfachsten Fall wird das zeitvariable Interpolationsfilter 3 durch einen linearen Interpolator (vergl. Fig. 5) realisiert. Sein Amplitudengang tp3 entspricht einem Tiefpaßverhalten und hat bei der doppelten Abtastfrequenz $2 \times f1$ eine Nullstelle, die im Bereich dieser Nullstelle mindestens den Dämpfungswert a4 (Fig. 2) aufweist Für die beabsichtigte Unterdrückung der Störfrequenzen ist dies ausreichend, Verbesserungen stellen selbstverständlich Interpolatoren höherer Ordnung dar. Die Vorgabe des Interpolationszeitpunktes wird durch die Steuereinrichtung 9 bestimmt, die ein entsprechendes Zeitdifferenzsignal td für jeden zu interpolierenden Abtastwert abgibt. Die Berechnung des jeweiligen Zeitdifferenzsignals td erfolgt aus der zeitlichen Auswertung der beiden Takte f1, f2 unter Einbeziehung der nächstliegenden Stützwerte.

Da mit derartigen Schaltungen zur Abtastratenumsetzung in der Regel eine deutliche Abtastratenreduktion durchgeführt wird, schließt sich der Filterkombination 1,2,3 die bereits genannte Dezimierungseinrichtung 4 an, mit der eine Abtastratenreduktion um einen ganzzahligen Faktor, insbesondere um eine Potenz von 2, durchführbar ist Für derartige Schaltungen eignen sich insbesondere MTA-Filter (= Moving Time Averager) einfacher oder höherer Ordnung wegen ihres einfachen Aufbaues. Der in der Dezimierungseinrichtung 4 vorhandene Tiefpaß ist vom jeweiligen Dezimierungsfaktor df abhängig, der ein mitlaufendes Datenfenster definiert, das je nach Filtergrad zur Bildung eines Mittelwertes aus gewichteten oder ungewichteten Abtastwerten dient Beim Dezimierungsfaktor 1 ist die Schaltung 4 unwirksam. In der Regel gibt die Steuereinrichtung 9 den jeweiligen ganzzahligen Dezimierungsfaktor df vor. Die Datenfolge d3 an der Klemme 4.2 ist zeitlich mit dem ersten Takt f1 verkoppelt. Den zeitlichen Ausgleich zum zweiten Takt f2 stellt der Pufferspeicher 6 her, dessen Eingang mit der ersten Taktquelle 7 und dessen Ausgang mit der zweiten Taktquelle 8 verbunden ist. Solange der zeitliche Aussteuerbereich des Interpolators 3 eine Oktave nicht überschreitet, ergeben sich keine Taktüberlappungsprobleme. Es ist auch möglich, daß der Pufferspeicher 6 zwischen dem zeitvariablen Interpolationsfilter 3 und der Dezimierungseinrichtung 4 eingefügt wird, dann wird auch die Taktsteuerung der Dezimierungsstufe 4 mit der zweiten Taktquelle 8 koppelbar.

Die in Figur 1 als Blockschaltbild dargestellte Schaltung läßt sich in den einzelnen Funktionseinheiten selbstverständlich ganz oder teilweise auch mittels eines schnellen Prozessors und zugehöriger Programme realisieren. Ein Zahlenbeispiel soll zeigen, wie die Änderung der Abtastrate auf die Filterkombination aufgeteilt wird. Soll die Abtastfrequenz um den Faktor 7,34 geändert werden, so vollzieht das hybride System eine Abtastwandlung um den Faktor 0,9175 und die Dezimierungseinrichtung eine Abtastratenreduktion um den Faktor 8. Das hybride System verdoppelt zuerst die Abtastrate (genau genommen wird nur die Anzahl der Abtastwerte verdoppelt und nicht der eigentliche Abtasttakt, siehe obige Ausführungen) und bildet über das Zeitdifferenzsignal td den Reduktionsfaktor 1,835.

In Fig. 2 ist das Frequenzschema der Eingangsdatenfolge d1 und der Amplitudengang a/dB der Filter von Fig. 1 dargestellt. Die Abtastfrequenz f1 beträgt 20,25 MHz. Die Eingangsdatenfolge d1 entspricht einem Videosignal dessen obere Grenzfrequenz etwa bei 6 MHz liegt. In der nächsten Zeile ist der weiche Amplitudengang tp1 des Eingangstiefpasses 1 dargestellt Die oberen Frequenzen des Videosignals d1, etwa ab 2,5 MHz, werden dabei bereits in der Amplitude abgesenkt. In der dritten Zeile ist der Amplitudengang tp2 des Tiefpasses im festen Interpolationsfilter 2 dargestellt Die Anhebung oder Absenkung höherer Signalbereiche entspricht dem Verlauf der gestrichelten Linie b im Durchlaßbereich. In der vierten Zeile ist der Amplitudengang tp3 eines linearen Interpolators 3 dargestellt, dessen beide Eingänge mit benachbarten Abtastwerten aus dem festen Interpolationsfilter 2 gespeist sind.

Der Amplitudengang a/dB der Filterkurven in Fig. 2 entspricht einer logarithmischen Darstellung und stellt für jede Kurve einen Bereich von etwa 45 dB dar. Die fünfte Zeile in Fig. 2 zeigt schließlich den Amplitudengang der gesamten Filterkombination nach der Dezimierungseinrichtung 4. In diesen Amplitudengang geht der eingestellte Wert der Abtastratenreduktion im hybriden Interpolationsfilter 2,3 und in der Dezimierungseinrichtung 4 ein. Für das dargestellte Beispiel ist angenommen, daß am Ausgang des zeitvariablen Interpolationsfilters 3 eine interpolierte Abtastfrequenz vorliegt, die 11 MHz entspricht und die dann schließlich in der Dezimierungseinrichtung 4 noch um den Faktor 8 reduziert wird. Der Amplitudengang tp4 entspricht somit einer Abtastratenreduktion um den Faktor 14,7, bei dem in der Eingangsdatenfolge d1 alle Frequenzen, die oberhalb von etwa 0,7 MHz liegen, unterdrückt werden müssen, was durch die Filterkombination 1,2,3,4 realisiert ist. Dieses schmalbandige Tiefpaßverhalten zeigt der Durchlaßbereich des Amplitudengangs tp4. Die Nebenmaxima des Amplitudengangs tp4 entsprechen dem theoretischen Amplitudengang eines MTA-Dezimierers, dessen Eingangsdatenfolge 11 MHz aufweist und dessen Dezimierungsfaktor df = 8 ist. Bei Videosignalen stören dies Nebenmaxima nicht mehr. Wenn die Dämpfung dort nicht ausreicht, dann muß lediglich ein MTA-Filter höherer Ordnung verwendet werden. Die Bereiche mit den Frequenzvielfachwerten von 11 MHz werden durch die erweiterte Filterkombination 1, 2, 3, 4 ausreichend gedämpft, so daß sie für die Ausgangsdatenfolge d2 vernachlässigbar sind. Durch die periodische Spiegelung der Amplitudengänge tp1 bis tp3 bei der Abtastfrequenz f1 und den Vielfachwerten davon, werden auch mögliche Störfrequenzen oberhalb der Abtastfrequenz unterdrückt.

In Fig. 3 ist ein Beispiel für einen Eingangstiefpaß 1 dargestellt, dessen Amplitudengang einem Tiefpaß zweiter Ordnung entspricht und die Übertragungsfunktion $H(z) = (1 + z^{-1})^2$ aufweist. Die Schaltung enthält zwei hintereinandergeschaltete Verzögerungsstufen 12.1, 12.2, deren jeweilige Verzögerungszeit T1 der Periode des ersten Taktes f1 gleich ist. Die drei Abgriffe an der Verzögerungskette sind einer Summierstufe 13 zugeführt, wobei der mittlere Abgriff über einen Multiplizierer 14 geführt ist, der eine Gewichtung mit dem Faktor 2 bewirkt.

Ein Beispiel für das feste Interpolationsfilter 2 ist in Fig. 4 dargestellt Es enthält eine Verzögerungskette aus drei Verzögerungsstufen 15.1, 15.2, 15.3 deren

jeweilige Verzögerungzeit T1 der Periodendauer des ersten Taktes f1 gleich ist. Durch unterschiedliche Verknüpfung der an der Verzögerungskette abgegriffenen Abtastwerte werden die einzelnen Frequenzkomponenten zur Bildung fester Stütz- oder Abtastwerte s(T), s(1,5T), s(2T) und s(2,5T) gebildet Das in Fig. 1 dargestellte Ausführungsbeispiel des festen Interpolationsfilters 2 zeichnet sich dadurch aus, daß es nur einen einzigen echten Multiplizierer, vier Verzögerungsstufen und vier Addierer/Subtrahierer erfordert. Die Schaltungskonfiguration mit der dreistufigen Verzögerungskette entspricht einem festen Interfpolationsfilter dritter Ordnung.

Die Filterkoeffizienten ändern sich bei diesem festen Interpolationsfilter 2 nicht, denn die gesuchten Abtastwerte liegen zeitlich gegenüber dem ursprünglichen Abtastraster fest, daraus folgt die Bezeichnung "festes Interpolationsfilter". Demgegenüber sind die Filterkoeffizienten des zeitvariablen Interpolationsfilters 3 von dem jeweiligen Wert des Zeitdifferenzsignals td abhängig, daraus folgt die Bezeichnung "zeitvariables Interpolationsfilter".

In dem Schaltungsbeispiel von Fig. 4 liegt der Eingang 2.1 der ersten Verzögerungsstufe 15.1 am ersten Eingang eines Addierers 17 und deren Ausgang am ersten Eingang eines Addierers 18, mit dessen zweitem Eingang der Eingang der dritten Verzögerungsstufe 15.3 verbunden ist, deren Ausgang am zweiten Eingang des ersten Addierers 17 liegt Der Ausgang des ersten Addierers 17 ist mit dem Minuend-Eingang und der Ausgang des zweiten Addierers 18 mit dem Subtrahend-Eingang eines Subtrahierers 19 verbunden, dessen Ausgang über einen Multiplizierst 16 mit dem ersten Eingang eines dritten Addierers 20 verbunden ist, dessen zweiter Eingang am Ausgang des zweiten Addierers 18 und dessen Ausgang über eine Stellen-Schiebestufe 21 mit einem Ausgang 2.12 und einer Verzögerungsstufe 15.4 verbunden ist. Die Schiebestufe 21 halbiert den Ausgangswert des dritten Addierers 20 und entspricht einem Multiplizierer, der aus einem Speicher 22 mit einem Multiplikationsfaktor 0,5 gespeist ist Beim Multiplizierer 16 handelt es sich um einen echten Multiplizierer, der den Wert der Signalkomponente aus dem Subtrahierer 19 verändert, die einem höheren Frequenzbereich der an der Klemme 2.1 zugeführten Datenfolge entspricht Durch einen aus einem Speicher 23 ausgelesenen Multiplikationsfaktor b wird diese Signalkomponente abgeschwächt oder verstärkt und mittels des dritten Addierers 20 dem gefilterten Signal zugeführt. Der Multiplikationsfaktor b stellt somit einen Filterkoeffizienten dar, dessen Aussteuerbereich etwa von -3/8 bis -1/8 reicht. Der Filterkoeffizient b bewirkt eine Anhebung oder Absenkung des Amplitudengangs für höhere Frequenzen, vgl. die gestrichelte Durchlaßkurve b im Frequenzdiagramm tp2 von Fig. 2.

Mit der Filterschaltung von Fig. 4 lassen sich vier Stützwerte s(T) bis s(2,5T) bestimmen, die gleichzeitig abgreifbar sind und Abtastwerten entsprechen, die jeweils um eine halbe Periode T1 des Eingangstaktes f1 auseinanderliegen. Der Ausgang der ersten Verzögerungsstufe 15.1 bildet den ersten Ausgangsanschluß 2.11, der Ausgang der Schiebestufe 21 bildet den zweiten Ausgang 2.12, der Ausgang der zweiten Verzögerungsstufe 15.2 bildet den dritten Ausgang 2.13 und der Ausgang der vierten Verzögerungsstufe 15.4 bildet schließlich den vierten Ausgang 2.14. Wenn das nachfolgende zeitvariable Interpolationsfilter 3 noch mehr Stützwerte benötigt, dann lassen sich diese mit ähnlichen Schaltungen erzeugen. Wenn das nachfolgende zeitvariable Interpolationsfilter 3 lediglich eine lineare Interpolation durchführt, dann werden nur die Ausgänge 2.11 bis 2.13 der Filteranordnung nach Fig. 4 benötigt. Eine Auswahlschaltung legt dann noch fest, für welches Abtastwertepaar s(T), s(1,5T); oder s(1,5T), s(2T) das Zeitdifferenzsignal dt am kleinsten ist und wählt dieses Abtastpaar für die nachfolgende Interpolation aus.

In Fig. 5 ist schematisch ein linearer Interpolator 3 dargestellt, der entsprechend dem Zeitdifferenzsignal dt eine beliebige Interpolation zwischen zwei Abtastwerten durchführt, die ihm an einem ersten und zweiten Anschluß 3.1, 3.2 zugeführt sind. Dabei werden die zugeführten Abtastwerte jeweils mittels einer vom Zeitdifferenzsignal td abhängigen Gewichtungseinrichtung 24, 25 gewichtet. Das Zeitdifferenzsignal td bestimmt, welchen linearen Anteil am Ausgangswert das erste und zweite Abtastsignal haben. Ein Multiplizierer 24 multipliziert den ersten Abtastwert an der Klemme 3.1 mit dem Zeitdifferenzsignal td und ein Multiplizierer 25 multipliziert den zweiten Abtastwert an der Klemme 3.2 mit dem Faktor 1-td. Ein Addierer 26 addiert beide resultierende Werte und die Summe an seinem Ausgang 33 ist der linear interpolierte Abtastwert. Bei dem Zeitdifferenzsignal td handelt es sich um ein auf die halbe Periodendauer $1/2 \times T1$ des Taktes f1 normierten Zahlenwert.

In Fig. 6 ist schematisch eine MTA-Dezimierungseinrichtung 4 dargestellt. Im einfachsten Fall enthält diese einen Akkumulator 27, einen Dezimierungsschalter 28 und einen Differenzierer 29. Bei MTA-Dezimierungseinrichtungen höherer Ordnung sind statt des einen Akkumulators 27 eine bestimmte Anzahl von Akkumulatoren hintereinandergeschaltet und entsprechend eine gleichgroße Anzahl von Differenzierern statt des einen Differenzierers 29. Die Akkumulatoren sind vom ersten Takt f1 gesteuert und die Differenzierer sowie der Dezimierungsschalter 28 vom Dezimierungstakt df. Die am Eingang 4.1 zugeführte Datenfolge wird im Akkumulator 27 aufaddiert. Mittels des Dezimierungsschalters 28 wird nach einer bestimmten Anzahl von Abtastwerten der Akkumulatorinhalt in den Differenzierer 29 gelesen, der von diesem Wert den dort gespeicherten Akkumulatorinhalt abzieht, also derjenigen Akkumulatorinhalt, der dem vorausgehenden Dezimierungszeitpunkt zugeordnet war. Die Funktionsweise der Dezimierungseinrichtung 4 entspricht damit der Mittelwertbildung über eine Anzahl von Abtastwerte, die durch ein mitlaufendes Datenfenster definiert sind, dessen Länge von dem Dezimierungsfaktor df abhängig ist. Die Mittelwertbildung erfordert wegen der verstärkenden Eigenschaft des MTA-Filters nach dem Akkumulator 27 oder dem Differenzierer 28 eine Normierungseinrichtung 30.. Wenn der Dezimierungsfaktor df eine Zweierpotenz ist, dann reicht eine einfache Stellenverschiebung oder eine neue Stellenzuordnung für die Normierung aus. In jedem Fall sollen am Ausgang 4.2 die gesuchten Abtastwerte der Ausgangsdatenfolge d2 amplitudenrichtig zur Verfügung stehen.

## Patentansprüche

1. Digitale Filterkombination zur Abtastratenumsetzung einer mit einem Digitalisierungstakt (f1) verknüpften ersten Datenfolge (d1) in eine zweite Datenfolge (d2) mit einer Serienschaltung aus:

   - einem digitalen Eingangstiefpaß (1), dessen ungespiegelter bzw. gespiegelter Amplitudengang (tp1) im Bereich der halben bzw. der 1,5-fachen Frequenz des Digitalisierungstaktes (f1) als Sperrdämpfung mindestens einem ersten Dämpfungswert (a1) entspricht, der im Bereich einer erforderlichen Gesamtdämpfung liegt, und dessen Amplitudengang im Bereich den Frequenz des Digitalisierungstaktes praktisch keine Dämpfung aufweist.

   - einem festen Interpolationsfilter (2), zur Erhöhung der Anzahl der Abtastwerte gegenüber der ersten Datenfolge (d1) um einen ganzzahligen Faktor, insbesondere um den Faktor 2, wobei

     -- der Amplitudengang (tp2) des festen Interpolationsfilters (2) im Bereich der Frequenz des Digitalisierungstaktes (f1) als Sperrdäpfung mindestens einem zweiten Dämpfungswert (a2) entspricht, der im Bereich der erforderlichen Gesamtdämpfung liegt, und

     -- im Frequenzbereich zwischen den durch den Eingangstiefpaß (1) definierten Sperrbereichen bei der halben und 1,5-fachen Frequenz des Digitalisierungstaktes (f1) als Sperrdämpfung mindestens einem zwischen dem zweiten Dämpfungswert (a2) und dem ungedämpften Durchlaßwert liegenden dritten Dämpfungswert (a3) entspricht, sodaß sich aus der Kombination von Eingangstiefpass und Interpolationsfilter ein resultierender Tiefpass ergibt, dessen Sperrbereich etwas unterhalb der halben Frequenz des Digitalisierungstaktes beginnt, und etwas über die 1.5-fache Frequenz des Digitalisierungstaktes hinausreicht, und

- einem zeitvariablen Interpolationsfilter (3), zur Interpolation einer vom Ausgang des festen Interpolationsfilters (2) gelieferten Datenfolge (d5), dabei hat der Amplitudengang (tp3) des zeitvariablen Interpolationsfilters (3) eine Tiefpaßcharakteristik mit einem Sperrbereich im Bereich der doppelten Frequenz des Digitalisierungstaktes (f1), dessen Sperrdämpfung mindestens einem vierten Dämpfungswert (a4) entspricht, der im Bereich der erforderlichen Gesamtdämpfung liegt.

2. Filterkombination nach Anspruch 1, **dadurch gekennzeichnet, daß** die Abtastrate und/oder die Anzahl der Abtastwerte einer Ausgangsdatenfolge (d6) des zeitvariablen Interpolationsfilters (3) mittels einer Dezimierungseinrichtung (4) um einen ganzzahligen Dezimierungsfaktor (df) reduziert ist.

3. Filterkombination nach einem der Ansprüche 1 bis 2, **dadurch gekennzeichnet, daß** der Eingangstiefpaß (1) durch eine Übertragungsfunktion $H(z) = (1+z^{-1})^p$ definiert ist, wobei p größer/gleich 2 ist.

4. Filterkombination nach einem der Ansprüche 1 bis 3, **dadurch gekennzeichnet, daß** das feste Interpolationsfilter (2) einen Amplitudengang (tp2) aufweist, der im Durchlaßbereich für höhere Frequenzen mittels eines zugeführten Koeffizienten (b) einstellbar ist.

5. Filterkombination nach einem der Ansprüche 1 bis 4, **dadurch gekennzeichnet, daß** das zeitvariable Interpolationsfilter (3) eine lineare Interpolation realisiert.

6. Filterkombination nach Anspruch 2, **dadurch gekennzeichnet, daß** die Dezimierungseinrichtung (4) im wesentlichen eine MTA-Filterstruktur aufweist.

7. Filterkombination nach Anspruch 6, **dadurch gekennzeichnet, daß** der Dezimierungsfaktor (df) ein Zweierpotenzwert ist.

8. Filterkombination nach Anspruch 7, **dadurch gekennzeichnet, daß** mittels einer Stellenschiebe- oder einer Stellenzuordnungseinrichtung (30), insbesondere in der Dezimierungseinrichtung (4), eine Amplitudennormierung erfolgt.

## Claims

1. A digital filter combination for performing a sampling rate conversion of a first data sequence (d1), which is locked with a digitization clock (f1), to a second data sequence (d2), comprising a series combination of:

   - a digital input low-pass filter (1) whose unmirrored and mirrored amplitude response (tp1) in the range of half and 1.5 times the frequency of the digitization clock (f1), respectively, as stop-band attenuation corresponds at least to a first attenuation value (a1) which lies in the range of a necessary total attenuation and whose amplitude response in the range of the frequency of the digitization clock shows virtually no attenuation;

   - a time-invariant interpolation filter (2) for increasing the number of samples from that of the first data sequence (d1) by an integral factor, particularly by a factor of 2, with the amplitude response (tp2) of the time-invariant interpolation filter (2)

      -- in the range of the frequency of the digitization clock (f1) as stop-band attenuation corresponding at least to a second attenuation value (a2) which lies in the range of the necessary total attenuation, and

      -- in the frequency range between the stop bands defined by the input low-pass filter (1) at half and 1.5 times the frequency of the digitization clock (f1) as stop-band attenuation corresponding at least to a third attenuation value (a3) which lies between the second attenuation value (a2) and the nonattenuated value, so that the combination of input low-pass filter and interpolation filter gives a resultant low-pass filter whose stop band begins slightly below half the frequency of the digitization clock and extends slightly beyond 1.5 times the frequency of the digitization clock; and

   - a time-varying interpolation filter (3) for interpolating a data sequence (d5) provided at the output of the time-invariant interpolation filter (2), the amplitude response (tp3) of the time-varying interpolation filter (3) having a low-pass characteristic with a stop band in the range of twice the frequency of the digitization clock (f1) whose stop-band attenuation corresponds at least to a fourth attenuation value (a4) which lies in the range of the necessary total attenuation.

**2.** A filter combination as set forth in claim 1, **characterized in that** the sampling rate and/or the number of samples of an output data sequence (d6) of the time-varying interpolation filter (3) are reduced by an integral decimation factor (df) by means of a decimator (4).

**3.** A filter combination as set forth in claim 1 or 2, **characterized in that** the input low-pass filter (1) is defined by a transfer function $H(z) = (1 + z^{-1})^p$, where p is greater than or equal to 2.

**4.** A filter combination as set forth in any one of claims 1 to 3, **characterized in that** the time-invariant interpolation filter (2) has an amplitude response (tp2) which is adjustable in the passband for higher frequencies by means of an applied coefficient (b).

**5.** A filter combination as set forth in any one of claims 1 to 4, **characterized in that** the time-varying interpolation filter (3) implements a linear interpolation.

**6.** A filter combination as set forth in claim 2, **characterized in that** the decimator (4) has essentially an MTA filter structure.

**7.** A filter combination as set forth in claim 6, **characterized in that** the decimation factor (df) is a power of two.

**8.** A filter combination as set forth in claim 7, **characterized in that** by means of a shift unit or bit allocation unit (30), particularly in the decimator (4), amplitude normalization is effected.

**Revendications**

**1.** Combinaison de filtres numériques destinée à la conversion de la fréquence d'échantillonnage d'une première suite de données (d1) formée à une première cadence de numérisation (f1) en une deuxième suite de données (d2) et comportant un circuit série constitué de :

- un filtre numérique passe-bas d'entrée (1) dont la réponse en amplitude (tp1), sans ou avec réflexion spéculaire, correspond, dans la zone de la moitié de ou de 1,5 fois la fréquence de la cadence de numérisation (f1), en tant qu'atténuation de blocage, à au moins une première valeur d'atténuation (a1) qui se trouve dans la fourchette d'une atténuation globale nécessaire et dont la réponse en amplitude ne présente pratiquement pas d'atténuation dans la zone de la cadence de numérisation (f1)
- un filtre interpolateur fixe (2) destiné à augmenter le nombre des valeurs d'échantillonnage par rapport à la première suite de données (d1) par un facteur entier, en particulier le facteur 2, combinaison dans laquelle

- la réponse en amplitude (tp2) du filtre interpolateur fixe (2) correspond, dans la zone de la cadence de numérisation (f1), en tant qu'atténuation de blocage, à au moins une deuxième valeur d'atténuation (a2) qui se trouve dans la fourchette de l'atténuation globale nécessaire, et
- dans la gamme des fréquences comprises entre les zones de blocage définies par le filtre passe-bas d'entrée (1) pour la moitié de ou 1,5 fois la fréquence de la cadence de numérisation (f1), il correspond, en tant qu'atténuation de blocage, une troisième valeur d'atténuation (a3) qui se trouve entre la deuxième valeur d'atténuation (a2) et la valeur de passage non atténué de telle manière que, à partir de la combinaison du filtre passe-bas d'entrée (1) et du filtre interpolateur fixe (2), on obtient un filtre passe-bas résultant dont la zone de blocage commence en dessous de la moitié de la fréquence de la cadence de numérisation (f1), et
- un filtre interpolateur à variation temporelle (3) destiné à l'interpolation d'une suite de données (d5) fournie par la sortie du filtre interpolateur fixe (2), la réponse en amplitude (tp3) du filtre interpolateur à variation temporelle (3) ayant une caractéristique de filtre passe-bas qui comporte une zone de blocage dans la zone du double de la fréquence de la cadence de numérisation (f1) et dont l'atténuation de blocage correspond au moins à une quatrième valeur d'atténuation (a4) qui se trouve dans la fourchette de l'atténuation globale nécessaire.

**2.** Combinaison de filtres selon la revendication 1, **caractérisé en ce que** la fréquence d'échantillonnage et/ou le nombre des valeurs d'échantillonnage d'une suite de données de sortie (d6) du filtre interpolateur à variation temporelle (3) sont réduits d'un facteur entier de décimation (df) au moyen d'un dispositif de décimation (4).

**3.** Combinaison de filtres selon l'une quelconque des revendications 1 à 2, **caractérisé en ce que** le filtre passe-bas d'entrée (1) est défini par une fonction de transfert

$$H(z) = (1 + z^{-1})^p$$

dans laquelle p est plus grand ou égal à 2.

**4.** Combinaison de filtres selon l'une quelconque des revendications 1 à 3, **caractérisé en ce que** le filtre interpolateur fixe (2) a une réponse en amplitude

**EP 0 889 588 B1**

(tp2) qui peut être réglée, dans la bande passante pour les fréquences élevées, au moyen d'un coefficient (b) qui y est envoyé.

5. Combinaison de filtres selon l'une quelconque des revendications 1 à 4, **caractérisé en ce que** le filtre interpolateur à variation temporelle (3) réalise une interpolation linéaire.

6. Combinaison de filtres selon la revendication 2, **caractérisé en ce que** le dispositif de décimation (4) présente essentiellement une structure de filtre MTA (Moving Time Averager).

7. Combinaison de filtres selon la revendication 6, **caractérisé en ce que** le facteur de décimation (df) est une puissance de 2.

8. Combinaison de filtres selon la revendication 7, **caractérisé en ce que** l'on réalise une normalisation d'amplitude au moyen d'un dispositif de décalage arithmétique ou d'attribution de valeurs (30), en particulier dans le dispositif de décimation.

EP 0 889 588 B1

Fig.1

Fig.2

Fig.4

Fig.3

Fig.5

Fig.6